(19) Europäisches Patentamt / European Patent Office / Office européen des brevets

(11) **EP 4 675 291 A1**

(12) **EUROPEAN PATENT APPLICATION**
published in accordance with Art. 153(4) EPC

(43) Date of publication:
07.01.2026 Bulletin 2026/02

(21) Application number: 24807575.6

(22) Date of filing: 16.05.2024

(51) International Patent Classification (IPC):
*G01R 31/392* (2019.01)   *G01R 31/396* (2019.01)
*G01R 31/385* (2019.01)   *G01R 31/12* (2020.01)
*G01R 19/10* (2006.01)   *G01R 19/30* (2006.01)
*G01R 19/00* (2006.01)   *G01R 19/165* (2006.01)

(52) Cooperative Patent Classification (CPC):
G01R 19/00; G01R 19/10; G01R 19/165;
G01R 19/30; G01R 31/12; G01R 31/385;
G01R 31/392; G01R 31/396; Y02E 60/10

(86) International application number:
PCT/KR2024/006658

(87) International publication number:
WO 2024/237704 (21.11.2024 Gazette 2024/47)

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: 17.05.2023 KR 20230064031

(71) Applicant: **LG ENERGY SOLUTION, LTD.**
**Seoul 07335 (KR)**

(72) Inventors:
- **LEE, Sun Jong**
  **Daejeon 34122 (KR)**
- **KIM, Cheol Taek**
  **Daejeon 34122 (KR)**

(74) Representative: **Plasseraud IP**
**104 Rue de Richelieu**
**CS92104**
**75080 Paris Cedex 02 (FR)**

(54) **BATTERY MANAGEMENT DEVICE AND OPERATING METHOD THEREOF**

(57) A battery management apparatus according to an embodiment disclosed herein includes a voltage measurement unit configured to measure a voltage of each of a plurality of battery banks and a controller configured to calculate a first voltage, which is a voltage variance of each of the plurality of battery banks in a specific period, calculate a second voltage of each of the plurality of battery banks based on a maximum value among first voltages of the plurality of battery banks and an average of the first voltage of each of the plurality of battery banks, and diagnose at least one battery bank among the plurality of battery banks based on an average value of second voltages of the plurality of battery banks and the second voltage of each of the plurality of battery banks.

START

MEASURE VOLTAGE OF EACH OF PLURALITY OF BATTERY BANKS — S201

CALCULATE FIRST VALUE, WHICH IS VOLTAGE VARIANCE OF EACH OF PLURALITY OF BATTERY BANS IN SPECIFIC PERIOD — S202

CALCULATE SECOND VOLTAGE OF EACH OF PLURALITY OF BATTERY BANKS BASED ON MAXIMUM VALUE AMONG FIRST VOLTAGES OF PLURALITY OF BATTERY BANKS AND AVERAGE OF FIRST VOLTAGE OF EACH OF PLURALITY OF BATTERY BANKS — S203

DIAGNOSE AT LEAST ONE BATTERY BANK AMONG PLURALITY OF BATTERY BANKS BASED ON AVERAGE OF SECOND VOLTAGES OF PLURALITY OF BATTERY BANKS AND SECOND VOLTAGE OF EACH OF PLURALITY OF BATTERY BANKS — S204

END

FIG.8

EP 4 675 291 A1

**Description**

**[Technical Field]**

CROSS-REFERENCE TO RELATED APPLICATION

This application claims priority to and the benefit of Korean Patent Application No. 10-2023-0064031 filed in the Korean Intellectual Property Office on May 17, 2023, the entire content of which is incorporated herein by reference.

TECHNICAL FIELD

Embodiments disclosed herein relate to a battery management apparatus and an operating method thereof.

**[Background Art]**

An electric vehicle is supplied with electricity from outside to charge a battery, and then a motor is driven by a voltage charged in the battery to obtain power. As batteries undergo internal transformation and denaturation through various charging and discharging at production and use stages, their physical and chemical properties change such that a defect may occur in which lithium ions from positive electrodes of the batteries are not reduced into negative electrodes and precipitate on surfaces of the negative electrodes. When lithium precipitation is repeated continuously, internal short may occur between the negative electrodes and the positive electrodes of the batteries, the batteries having the inner short may experience under-voltage defects in which voltages are reduced to a specific level or lower or undergo an increase in the possibility of ignition. Thus, a method of diagnosing lithium precipitation of a battery is required.

A conventional method of diagnosing lithium precipitation uses voltage data of a rest period after charging of a battery in which a large amount of lithium precipitation of a battery occurs, but a corresponding method has a problem in which it is difficult to determine an abnormal voltage because of a minimal influence upon a measured voltage of the battery.

**[Disclosure]**

**[Technical Problem]**

Embodiments disclosed herein aim to provide a battery management apparatus and an operating method thereof in which a battery bank may be accurately diagnosed using an abnormal behavior of a voltage in a rest period of the battery bank.

Technical problems of the embodiments disclosed herein are not limited to the above-described technical problems, and other unmentioned technical problems would be clearly understood by one of ordinary skill in the art from the following description.

**[Technical Solution]**

A battery management apparatus according to an embodiment disclosed herein includes a voltage measurement unit configured to measure a voltage of each of a plurality of battery banks and a controller configured to calculate a first voltage, which is a voltage variance of each of the plurality of battery banks in a specific period, calculate a second voltage of each of the plurality of battery banks based on a maximum value among first voltages of the plurality of battery banks and an average of the first voltage of each of the plurality of battery banks, and diagnose at least one battery bank among the plurality of battery banks based on an average value of second voltages of the plurality of battery banks and the second voltage of each of the plurality of battery banks.

According to an embodiment, the controller may be further configured to initialize the first voltage of each of the plurality of battery banks when the maximum value among the first voltages of the plurality of battery banks is less than or equal to a lower threshold (LT).

According to an embodiment, the controller may be further configured to accumulate the first voltage of each of the plurality of battery banks when the maximum value among the first voltages of the plurality of battery banks exceeds the LT and the average the first voltages of the plurality of battery banks is less than an upper threshold (UT).

According to an embodiment, the controller may be further configured to calculate the first voltage of each of the plurality of battery banks as the second voltage of each of the plurality of battery banks when the maximum value among the first voltages of the plurality of battery banks exceeds the LT and the average the first voltages of the plurality of battery banks is greater than or equal to the UT.

According to an embodiment, the controller may be further configured to calculate, as a reference value of each of the plurality of battery banks, a ratio of the second voltage of the plurality of battery banks with respect to the maximum value between the average of the second voltages of the plurality of battery banks and the UT.

According to an embodiment, the controller may be further configured to set a rank of each of the plurality of battery banks based on the reference value of each of the plurality of battery banks.

According to an embodiment, the controller may be further configured to set a rank according to an order in which the plurality of battery banks are listed in an ascending order of the reference value, and determine a first battery bank in a first rank and a second battery bank in a second rank among the plurality of battery banks.

According to an embodiment, the controller may be further configured to calculate a first deviation which is a difference between a reference value of the first battery bank and a reference value of the second battery bank, calculate a second deviation which is a difference between a second voltage of the first battery bank and an average value of second voltages of the plurality of battery banks, and diagnose the first battery bank based on the first deviation and the second deviation.

According to an embodiment, the controller may be further configured to diagnose the first battery bank when the reference value of the first battery bank exceeds a first threshold, the first deviation is less than a second threshold, and the second deviation exceeds a third threshold.

An operating method of a battery management apparatus according to an embodiment disclosed herein includes measuring a voltage of each of a plurality of battery banks, calculating a first voltage, which is a voltage variance of each of the plurality of battery banks in a specific period, calculating a second voltage of each of the plurality of battery banks based on a maximum value among first voltages of the plurality of battery banks and an average of the first voltage of each of the plurality of battery banks, and diagnosing at least one battery bank among the plurality of battery banks based on an average value of second voltages of the plurality of battery banks and the second voltage of each of the plurality of battery banks.

According to an embodiment, the calculating of the second voltage of each of the plurality of battery banks based on the maximum value among the first voltages of the plurality of battery banks and the average of the first voltage of each of the plurality of battery banks may include initializing the first voltage of each of the plurality of battery banks when the maximum value among the first voltages of the plurality of battery banks is less than or equal to a lower threshold (LT).

According to an embodiment, the calculating of the second voltage of each of the plurality of battery banks based on the maximum value among the first voltages of the plurality of battery banks and the average of the first voltage of each of the plurality of battery banks may include accumulating the first voltage of each of the plurality of battery banks when the maximum value among the first voltages of the plurality of battery banks exceeds the LT and the average the first voltages of the plurality of battery banks is less than an upper threshold (UT).

According to an embodiment, the calculating of the second voltage of each of the plurality of battery banks based on the maximum value among the first voltages of the plurality of battery banks and the average of the first voltage of each of the plurality of battery banks may include calculating the first voltage of each of the plurality of battery banks as the second voltage of each of the plurality of battery banks when the maximum value among the first voltages of the plurality of battery banks exceeds the LT and the average the first voltages of the plurality of battery banks is greater than or equal to the UT.

According to an embodiment, the setting of the rank of each of the plurality of battery banks based on the reference value which is a ratio of the second voltage of each of the plurality of battery banks with respect to an average of the second voltages of the plurality of battery banks may include calculating, as a reference value of each of the plurality of battery banks, a ratio of the second voltage of the plurality of battery banks with respect to the maximum value between the average of the second voltages of the plurality of battery banks and the UT.

According to an embodiment, the diagnosing of the at least one battery bank among the plurality of battery banks based on the average value of the second voltages of the plurality of battery banks and the second voltage of each of the plurality of battery banks may include setting a rank of each of the plurality of battery banks based on the reference value of each of the plurality of battery banks.

According to an embodiment, the diagnosing of the at least one battery bank among the plurality of battery banks based on the average value of the second voltages of the plurality of battery banks and the second voltage of each of the plurality of battery banks may include setting a rank according to an order in which the plurality of battery banks are listed in an ascending order of the reference value, and determine a first battery bank in a first rank and a second battery bank in a second rank among the plurality of battery banks.

According to an embodiment, the diagnosing of the at least one battery bank among the plurality of battery banks based on the average value of the second voltages of the plurality of battery banks and the second voltage of each of the plurality of battery banks may include calculating a first deviation which is a difference between a reference value of the first battery bank and a reference value of the second battery bank, calculating a second deviation which is a difference between a second voltage of the first battery bank and an average value of second voltages of the plurality of battery banks, and diagnosing the first battery bank based on the first deviation and the second deviation.

According to an embodiment, the diagnosing of the at least one battery bank among the plurality of battery banks based on the average value of the second voltages of the plurality of battery banks and the second voltage of each of the plurality of battery banks may include diagnosing the first battery bank when the reference value of the first battery bank exceeds a first threshold, the first deviation is less than a second threshold, and the second deviation exceeds a third threshold.

**[Advantageous Effects]**

With the battery management apparatus and the operating method thereof according to an embodiment disclosed herein, a battery bank may be accurately diagnosed using an abnormal behavior of a voltage in a rest period of the battery bank.

**[Description of Drawings]**

FIG. 1 illustrates a battery pack according to an embodiment disclosed herein.
FIG. 2 is a block diagram illustrating a configuration of a battery management apparatus, according to an embodiment disclosed herein.
FIG. 3 is a graph showing a voltage change in a rest period of a battery bank according to an embodiment disclosed herein.
FIG. 4 is a graph showing a change of a first voltage of a battery bank according to an embodiment disclosed herein.
FIG. 5 is a graph showing an accumulated change of a first voltage of a battery bank according to an embodiment disclosed herein.
FIG. 6 is a graph showing a change in a reference value of a battery bank according to an embodiment disclosed herein.
FIG. 7 is a flowchart of a method of diagnosing a battery bank by a controller, according to an embodiment disclosed herein.
FIG. 8 is a flowchart showing an operating method of a battery management apparatus, according to an embodiment disclosed herein.
FIG. 9 is a flowchart of an operating method of a battery management apparatus according to another embodiment disclosed herein.
FIG. 10 is a block diagram showing a hardware configuration of a computing system for performing an operating method of a battery management apparatus, according to an embodiment disclosed herein.

**[Mode for Invention]**

Hereinafter, some embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present document.

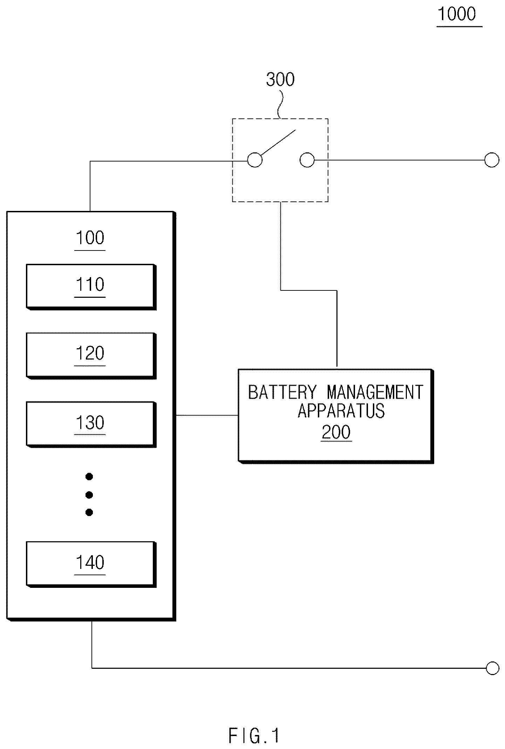

FIG. 1 illustrates a battery pack according to an embodiment disclosed herein.

Referring to FIG. 1, a battery pack 1000 according to an embodiment disclosed herein may include a battery module 100, a battery management apparatus 200, and a relay 300. According to various embodiments, the battery module 100 may be a battery cell, and in this case, the battery pack 1000 may have a cell-to-pack structure.

While it is shown in FIG. 1 that the battery module 100 is one, the battery pack 1000 may include a plurality of battery modules that form a stacked structure. The battery module 100 may include a plurality of battery banks 110, 120, 130, and 140. Although the plurality of battery banks are illustrated as four in FIG. 1, the present disclosure is not limited thereto, and the battery module 100 may include n battery banks (n is a natural number equal to or greater than 2).

The battery module 100 may supply power to a target device (not shown). To this end, the battery module 100 may be electrically connected to the target device. Herein, the target device may include an electrical, electronic, or mechanical device that operates by receiving power from the battery pack 1000 including the battery module 100, and the target device may be, for example, an electric vehicle (EV) or an energy storage system (ESS), but is not limited thereto.

The battery module 100 may include a plurality of battery banks 110, 120, 130, and 140. Herein, the battery bank may be defined as one serial line including a plurality of battery cells in the battery module 100. Depending on an embodiment, the plurality of battery banks 110, 120, 130, and 140 may be connected in series to each other in the battery module 100. Although the plurality of battery banks 110, 120, 130, and 140 are illustrated as four in FIG. 1, the present disclosure is not limited thereto, and the battery module 100 may include n battery banks (n is a natural number equal to or greater than 2). Depending on an embodiment, the plurality of battery banks 110, 120, 130, and 140 may be electrically connected to each other to constitute a cell module assembly (CMA).

The plurality of battery banks 110, 120, 130, and 140 may include a plurality of battery cells. The battery cell, which is a basic unit of a battery available by charging and discharging electrical energy, may be a lithium ion (Li-ion) battery, an Li-ion polymer battery, a nickel-cadmium (Ni-Cd) battery, a nickel hydrogen (Ni-MH) battery, etc., and is not limited thereto. According to various embodiments, the plurality of battery banks 110, 120, 130, and 140 may be respectively single battery cells. The plurality of battery cells included in each of the plurality of battery banks 110, 120, 130, and 140 may be connected in parallel to each other. The number of battery cells connected in parallel in the plurality of battery banks, 110, 120, 130, and 140 may be the same.

The battery management apparatus (a battery management system (BMS)) 200 may manage and/or control a state and/or an operation of the battery module 100. For example, the battery management apparatus 200 may manage and/or control the states and/or operations of the plurality of battery banks 110, 120, 130, and 140 included in the battery module 100. The battery management apparatus 200 may manage charging and/or discharging of the battery module 100.

The battery management apparatus 200 may control an operation of the relay 300. For example, the battery management apparatus 200 may short-circuit the relay 300 to supply power to the target device. The battery management apparatus 200 may short-circuit the relay 300 when a charging device is connected to the battery pack 1000.

In addition, the battery management apparatus 200 may monitor a voltage, a current, a temperature, etc., of the battery module 100 and/or each of the plurality of battery banks 110, 120, 130, and 140 included in the battery module 100. A sensor or various measurement modules for monitoring performed by the battery management apparatus 200, which are not shown, may be additionally installed in the battery module 100, a charging/discharging path, any position of the battery module 100, etc. The battery management apparatus 200 may calculate a parameter indicating a state of the battery module 100, e.g., a state of charge (SOC), a state of health (SOH) etc., based on a measurement value such as monitored voltage, current, temperature, etc.

For the plurality of battery banks 110, 120, 130, and 140, as a period of use or the number of times of use increases, a capacity may decrease, internal resistance may increase, and in this way, various factors in the battery banks may change. The battery management apparatus 200 may diagnose an abnormal phenomenon inside the plurality of battery banks 110, 120, 130, and 140 based on data of various factors changing with deterioration of the battery banks.

Specifically, the battery management apparatus 200 may diagnose, among the plurality of battery banks 110, 120, 130, and 140, a battery bank including a battery cell having short-circuit in an electrode tab thereof or having both the short-circuit in the electrode tab and lithium precipitation, by using voltage data of the plurality of battery banks 110, 120, 130, and 140. Herein, lithium precipitation refers to a phenomenon in which lithium ions from a positive electrode during charging of a battery cell fail to be chemically coupled to a negative electrode and exist in the form of metal on a surface of the negative electrode. For a normal battery cell, lithium ions from a positive electrode of the battery cell are reduced into a negative electrode, but for a defective battery cell, some lithium ions may precipitate in the form of lithium metal on a surface of the negative electrode. When lithium precipitation repetitively occurs and thus a lithium byproduct grows, contact of the lithium byproduct with a positive electrode or a positive electrode collector may cause inner short between a negative electrode and the positive electrode of the battery cell. A battery bank in which inner short occurs may have a voltage deviation with a normal battery bank due to self-discharge over time.

In addition, a battery cell may have a disconnection at a positive or negative tab due to various reasons such as defects at the production stage, internal deformation and denaturation through multiple a plurality of charging and discharging, external shock, etc. In this case, when lithium precipitation and electrode tab disconnection occur together in the battery cell, the electrode of the disconnected battery cell and the electrode of the normal battery cell may be connected to each other by a lithium precipitate. Herein, when the negative electrode of the disconnected battery cell has a higher state of charge (SOC) than the negative electrode of the normal battery, the negative electrodes of the two battery cells contact with each other by the lithium precipitate such that charging may occur from the negative electrode of the disconnected battery cell to the negative electrode of the normal battery. Thus, the battery cell having lithium precipitation and disconnection in the electrode tab together may undergo faster and larger voltage change than the normal battery cell.

Thus, the battery management apparatus 200 may compare voltage data in a rest period of a battery bank with statistical normal voltage data in a rest period of a normal battery bank to diagnose a battery bank including a battery cell having electrode tab disconnection and lithium precipitation, by using a phenomenon in which the battery cell having electrode tab disconnection and lithium precipitation occurring together has a faster and larger voltage change than the normal battery cell in a rest period.

The following operation of the battery management apparatus 200 may also be performed in the battery management apparatus 200 or various devices such as a server, a cloud, a charger, a charger/discharger, etc., connected to a vehicle having the battery management apparatus 200 mounted thereon.

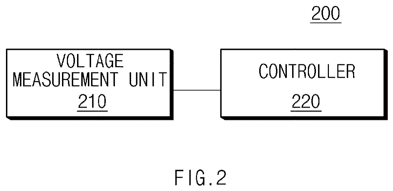

FIG. 2 is a block diagram illustrating a configuration of a battery management apparatus, according to an embodiment disclosed herein.

Hereinbelow, a configuration of the battery management apparatus 200 will be described in detail with reference to FIG. 2.

Referring to FIG. 2, the battery management apparatus 200 may include a voltage measurement unit 210 and a controller 220.

The voltage measurement unit 210 may calculate the voltage of each of the plurality of battery banks 110, 120, 130, and 140. The voltage measurement unit 210 may calculate time-series voltage data of each of the plurality of battery cells 110, 120, 130, and 140. Specifically, the voltage measurement unit 210 may calculate voltage rise and drop and long-term relaxation data of the plurality of battery banks110, 120, 130, and 140 in charging, discharging, and rest periods.

The voltage measurement unit 210 may calculate the voltage of each of the plurality of battery banks 110, 120, 130, and 140 in the rest period after charging or discharging of the plurality of battery banks 110, 120, 130, and 140.

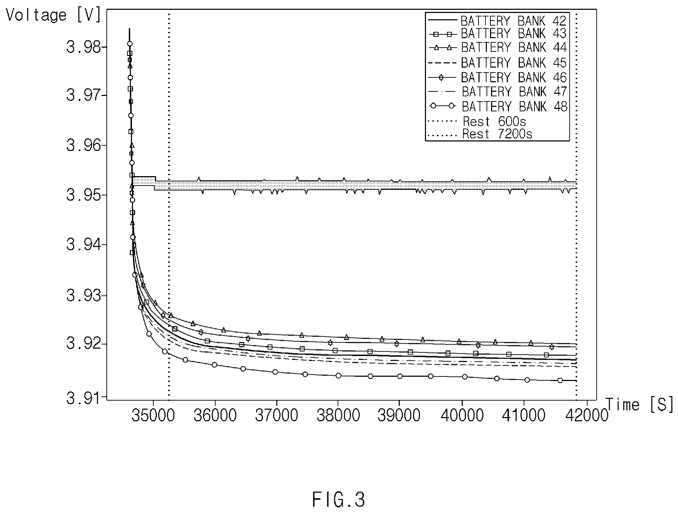

FIG. 3 is a graph showing a voltage change in a rest period of a battery bank according to an embodiment disclosed herein.

Referring to FIG. 3, the voltage measurement unit 210 may calculate the voltage of each of the plurality of battery banks 110, 120, 130, and 140 in the rest period to calculate voltage change data of each of the plurality of battery banks 110, 120, 130, and 140. In the rest period, the battery bank having the disconnected electrode tab may have a faster and larger voltage change than the normal battery bank. Thus, the voltage measurement unit 210 may generate a graph indicating a voltage change of each of the plurality of battery banks 110, 120, 130, and 140 by measuring the voltage of each of the plurality of battery banks 110, 120, 130, and 140 in the rest period.

The voltage measurement unit 210 may calculate a voltage of each of the plurality of battery banks 110, 120, 130, and 140 at specific intervals set from a point in time after the elapse of a specific time of the rest period of the plurality of battery banks 110, 120, 130, and 140 and accumulate a voltage variance of each of the plurality of battery banks 110, 120, 130, and 140. Herein, the specific time may include, e.g., 600 seconds, and the specific period may include, e.g., 200 seconds or 600 seconds. For example, the voltage measurement unit 210 may calculate the voltage of each of the plurality of battery banks 110, 120, 130, and 140 at intervals of 200 seconds or 600 seconds from a point in time after the elapse of 600 seconds of the rest period of the plurality of battery banks 110, 120, 130, and 140.

The controller 220 may calculate a first voltage $\Delta V$ that is a voltage variance of each of the plurality of battery banks 110, 120, 130, and 140 in a specific period. For example, the controller 220 may calculate the first voltage $\Delta V$ that is a voltage variance during 200 seconds or 600 seconds from a point in time after the elapse of 600 seconds of the rest period of each of the plurality of battery banks 110, 120, 130, and 140. That is, the controller 220 may compare a voltage measured at a point in time after the elapse of 600 seconds from a rest period of each of the plurality of battery banks 110, 120, 130, and 140 with a voltage measured at a point in time after the elapse of 800 seconds or 1200 seconds from the rest period to calculate the first voltage $\Delta V$ that is a voltage variance of each of the plurality of battery banks 110, 120, 130, and 140.

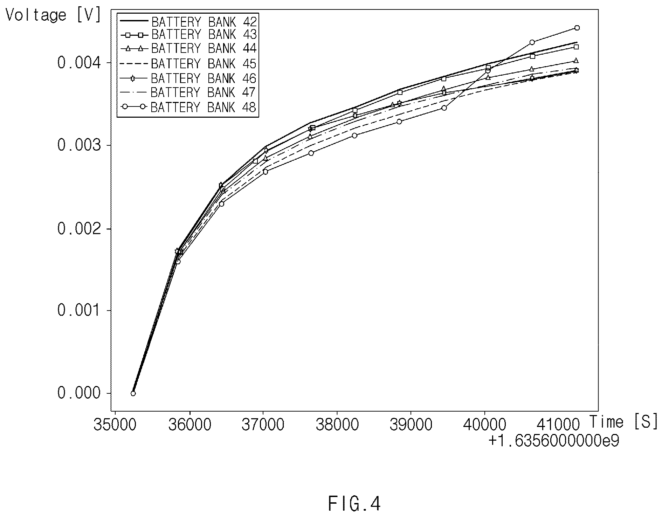

FIG. 4 is a graph showing a change of a first voltage of a battery bank according to an embodiment disclosed herein.

Referring to FIG. 4, the controller 220 may repeatedly calculate the first voltage $\Delta V$ of each of the plurality of battery banks 110, 120, 130, and 140 at specific intervals. For example, the controller 220 may repeatedly calculate the first voltage $\Delta V$ of each of the plurality of battery banks 110, 120, 130, and 140 at intervals of 200 seconds or 600 seconds. That is, the controller 220 may continuously compare a voltage measured at a point in time after the elapse of 600 seconds from a rest period of each of the plurality of battery banks 110, 120, 130, and 140, a voltage measured at a point in time after the elapse of 800 seconds from the rest period, and a voltage measured at a point in time after the elapse of 1000 seconds from the rest period with one another to calculate a change in the first voltage $\Delta V$ for each of the plurality of battery banks 110, 120, 130, and 140 at intervals of 200 seconds or 600 seconds.

The controller 220 may calculate a maximum value Max[$\Delta V$] among the first voltages $\Delta V$ of the plurality of battery banks 110, 120, 130, and 140. For example, the controller 220 may calculate a maximum value Max[$\Delta V$] among the first voltages $\Delta V$ of the plurality of battery banks 110, 120, 130, and 140 included in the same battery module.

The controller 220 may calculate an average $\Delta V\_avg$ of the first voltage of each of the plurality of battery banks 110, 120, 130, and 140. Specifically, the controller 220 may calculate the average $AV\_avg$ of the first voltage of each of the plurality of battery banks 110, 120, 130, and 140 by using the first voltage $\Delta V$ of each of the plurality of battery banks 110, 120, 130, and 140, repeatedly measured up to a point in time at which the average $AV\_avg$ of the first voltage of each of the plurality of battery banks 110, 120, 130, and 140 is calculated.

The controller 220 may compare the maximum value Max[$\Delta$V] among the first voltages $\Delta$V of the plurality of battery banks 110, 120, 130, and 140 and the average $\Delta$V_avg of the first voltage $\Delta$V of each of the plurality of battery banks 110, 120, 130, and 140 with a threshold. The controller 220 may correct the first voltage $\Delta$V of each of the plurality of battery banks 110, 120, 130, and 140 based on a result of comparing the maximum value Max[$\Delta$V] among the first voltages $\Delta$V of the plurality of battery banks 110, 120, 130, and 140 and the average $\Delta$V_avg of the first voltage $\Delta$V of each of the plurality of battery banks 110, 120, 130, and 140 with the threshold.

First, the controller 220 may determine whether the maximum value Max[$\Delta$V] among the first voltages $\Delta$V of the plurality of battery banks 110, 120, 130, and 140 exceeds a lower threshold (LT). Herein, the LT may be related to a noise level for determining whether the first voltage $\Delta$V of each of the plurality of battery banks 110, 120, 130, and 140 is noise data. That is, the controller 220 may compare the maximum value Max[$\Delta$V] among the first voltages $\Delta$V of the plurality of battery banks 110, 120, 130, and 140 with the LT to determine whether the first voltage $\Delta$V of each of the plurality of battery banks 110, 120, 130, and 140 is noise data unavailable to diagnosis of a battery bank because of being extremely small. Herein, the LT may be, for example, '0.5 mV'.

According to an embodiment, the controller 220 may initialize the first voltage $\Delta$V of each of the plurality of battery banks 110, 120, 130, and 140 when the maximum value Max[$\Delta$V] among the first voltages $\Delta$V of the plurality of battery banks 110, 120, 130, and 140 is less than or equal to the LT. That is, the controller 220 may determine the first voltage $\Delta$V of each of the plurality of battery banks 110, 120, 130, and 140 as noise data and initialize the first voltage $\Delta$V without using the same for diagnosis of the battery bank, when the maximum value Max[$\Delta$V] among the first voltages $\Delta$V of the plurality of battery banks 110, 120, 130, and 140 is less than or equal to the LT.

According to an embodiment, the controller 220 may maintain the first voltage $\Delta$V of each of the plurality of battery banks 110, 120, 130, and 140 when the maximum value Max[$\Delta$V] among the first voltages $\Delta$V of the plurality of battery banks 110, 120, 130, and 140 exceeds the LT. That is, the controller 220 may regard the magnitude of the first voltage $\Delta$V of each of the plurality of battery banks 110, 120, 130, and 140 as being unignorable as noise data and use the first voltage $\Delta$V for diagnosis of the battery bank, when the maximum value Max[$\Delta$V] among the first voltages $\Delta$V of the plurality of battery banks 110, 120, 130, and 140 exceeds the LT.

According to an embodiment, the controller 220 may accumulate the first voltage $\Delta$V of the battery bank when the maximum value Max[$\Delta$V] among the first voltages $\Delta$V of the plurality of battery banks 110, 120, 130, and 140 exceeds the LT and the average $\Delta$V_avg of the first voltage of at least one of the plurality of battery banks 110, 120, 130, and 140 is less than an UT. Herein, the UT may be, for example, '1 mV'.

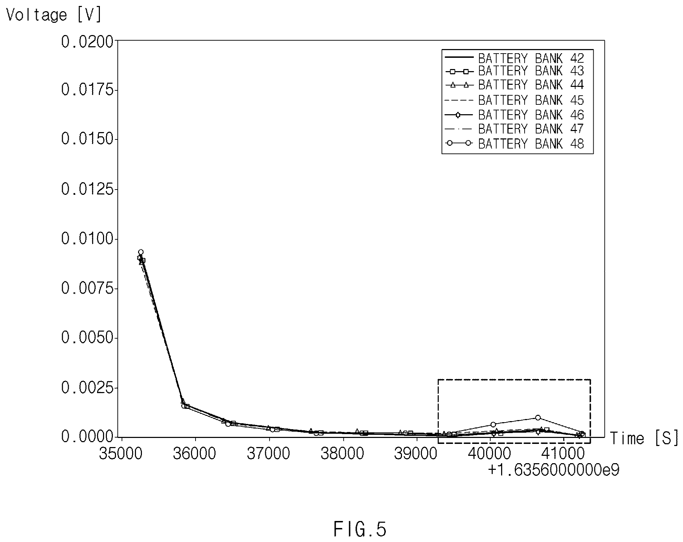

FIG. 5 is a graph showing an accumulated change of a first voltage of a battery bank according to an embodiment disclosed herein.

Referring to FIG. 5, the controller 220 may accumulate the first voltage $\Delta$V of the battery bank to diagnose the battery bank based on the accumulated amount of the first voltage $\Delta$V in several periods when the maximum value Max[$\Delta$V] among the first voltages $\Delta$V of the plurality of battery banks 110, 120, 130, and 140 exceeds the LT and the average $\Delta$V_avg of the first voltage of at least one of the plurality of battery banks 110, 120, 130, and 140 is less than the UT.

That is, when the maximum value Max[$\Delta$V] among the first voltages $\Delta$V of the plurality of battery banks 110, 120, 130, and 140 exceeds the LT and the average $\Delta$V_avg of the first voltage of at least one of the plurality of battery banks 110, 120, 130, and 140 is less than the UT, the controller 220 may not determine the first voltage $\Delta$V as noise data, but as the magnitude of the first voltage $\Delta$V is not sufficient to diagnose the battery bank, the controller 220 may accumulate the first voltage $\Delta$V of the battery bank to diagnose the battery bank based on the accumulated amount of the first voltage $\Delta$V in several periods. Thus, the controller 220 may calculate a voltage of each of the plurality of battery banks 110, 120, 130, and 140 after the elapse of a specific period, add a newly calculated first voltage $\Delta$V to a previously stored first voltage $\Delta$V, and compare the accumulatively calculated first voltage $\Delta$V with the LT and the UT.

According to an embodiment, the controller 220 may accumulate the first voltage $\Delta$V of the battery bank when the maximum value Max[$\Delta$V] among the first voltages $\Delta$V of the plurality of battery banks 110, 120, 130, and 140 exceeds the LT and the average $\Delta$V_avg of the first voltage of at least one of the plurality of battery banks 110, 120, 130, and 140 is greater than or equal to the UT. That is, the controller 220 may set the UT to prevent the first voltage $\Delta$V of each of the plurality of battery banks 110, 120, 130, and 140 from being continuously accumulated. When the average $\Delta$V_avg of the first voltage $\Delta$V of at least one of the plurality of battery banks 110, 120, 130, and 140 is greater than or equal to the UT, the controller 220 may accumulate the first voltage $\Delta$V of the battery bank up to a point in time at which the average $\Delta$V_avg is determined to be greater than or equal to the UT, thereby calculating a second voltage $\Delta$V' of the battery bank.

The controller 220 may compare the first voltage $\Delta$V of each of the plurality of battery banks 110, 120, 130, and 140 with the LT and the UT to initialize the first voltage $\Delta$V determined as noise data or accumulate the first voltage $\Delta$V in several periods to prevent false positive of the battery bank due to application of the noise data.

The controller 220 may calculate an average $\Delta$V'_avg of the second voltage $\Delta$V' of each of the plurality of battery banks 110, 120, 130, and 140. The controller 220 may calculate a maximum value Max between the average $\Delta$V'_avg of the second voltage $\Delta$V' of each of the plurality of battery banks 110, 120, 130, and 140 and the UT.

The controller 220 may calculate a ratio of the second voltage ΔV' of each of the plurality of battery banks with respect to the maximum value between the average ΔV'_avg of the second voltage ΔV' of each of the plurality of battery banks 110, 120, 130, and 140 and the UT. Specifically, the controller 220 may calculate a ratio of the second voltage ΔV' of each of the plurality of battery banks with respect to the maximum value between the average ΔV'_avg of the second voltage ΔV' of each of the plurality of battery banks 110, 120, 130, and 140 and the UT, as a reference value R of each of the plurality of battery banks 110, 120, 130, and 140.

The controller 220 may calculate the reference value R of each of the plurality of battery banks 110, 120, 130, and 140, based on Equation 1.

[Equation 1]

$$\text{Value (R)} = \frac{\text{Second Voltage } (\Delta V')}{\text{Max}\,[\Delta V'\_\text{avg}, \text{UT}]}$$

The controller 220 may use a Max function for a denominator of [Equation 1] that calculates the reference value R. Specifically, the controller 220 may input a maximum value between the average ΔV'_avg of the second voltage ΔV' of the plurality of battery banks 110, 120, 130, and 140 and the UT into the denominator of [Equation 1].

The controller 220 may be configured to diagnose a battery bank using the reference value R when a magnitude of the second voltage ΔV' of the battery bank is greater than or equal to a specific level by using the Max function for the denominator of [Equation 1]. That is, the controller 220 may be configured to diagnose a battery bank using the Max function for the denominator of [Equation 1] when the magnitude of the second voltage ΔV' of the battery bank is greater than or equal to the UT that is the noise level.

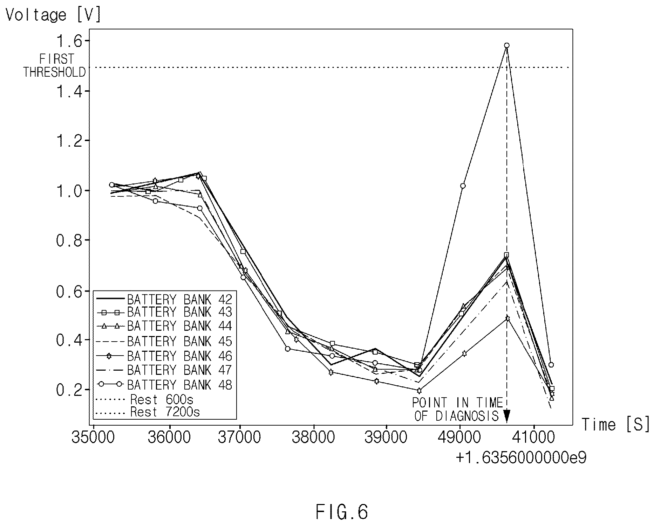

FIG. 6 is a graph showing a change in a reference value of a battery bank according to an embodiment disclosed herein.

Referring to FIG. 6, the controller 220 may calculate the reference value R of each of the plurality of battery banks 110, 120, 130, and 140 at specific intervals. For example, the controller 220 may calculate the first voltage ΔV of each of the plurality of battery banks 110, 120, 130, and 140 and the second voltage ΔV' obtained by correcting the first voltage ΔV at intervals of 200 seconds or 600 seconds, and calculate the reference value R of each of the plurality of battery banks 110, 120, 130, and 140 at intervals of 200 seconds or 600 seconds by using the calculated second voltage ΔV'.

The controller 220 may set a rank of each of the plurality of battery banks 110, 120, 130, and 140 based on the reference value R of each of the plurality of battery banks 110, 120, 130, and 140. The controller 220 may list the plurality of battery banks 110, 120, 130, and 140 in a descending order with a larger reference value R. The controller 220 may sequentially set a rank according to an order in which the plurality of battery banks 110, 120, 130, and 140 are listed based on the reference values R. The controller 220 may determine a bank listed in a first rank based on the reference value R as a first battery bank B1 and a bank listed in a second rank based on the reference values R as a second battery bank B2, among the plurality of battery banks 110, 120, 130, and 140.

The controller 220 may determine the first battery bank B1 that is a potential diagnosis target based on the reference value R of each of the plurality of battery banks 110, 120, 130, and 140.

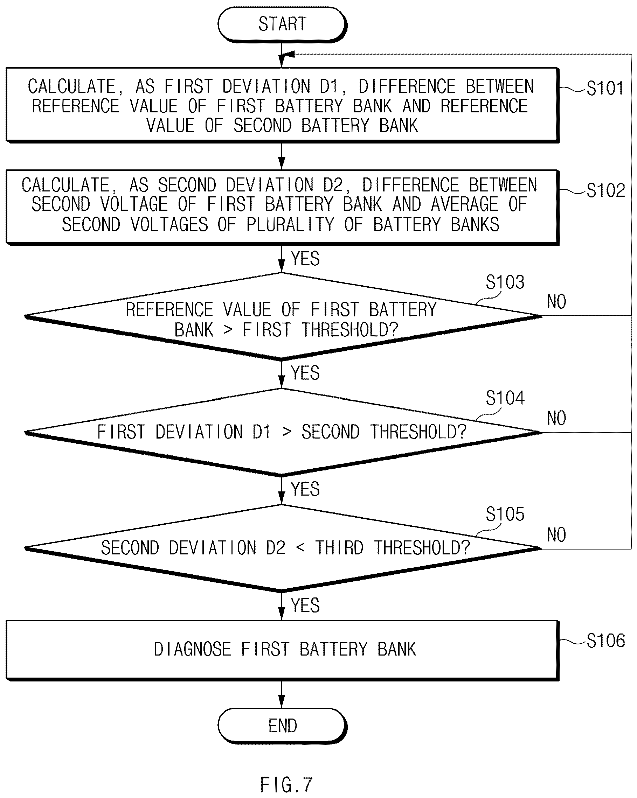

FIG. 7 is a flowchart of a method of diagnosing a battery bank by a controller, according to an embodiment disclosed herein.

Hereinbelow, a method, performed by the controller 220, of diagnosing a battery bank based on the reference value R of each of the plurality of battery banks 110, 120, 130, and 140 will be described in detail with reference to FIG. 7.

In operation S101, the controller 220 may calculate a difference 'R_B1 - R_B2' between a reference value R_B1 of the first battery bank B1 and a reference value R_B2 of the second battery bank B2 as a first deviation D1. In operation S101, the controller 220 may calculate, as a first deviation D1, a difference 'R_B1 - R_B2' between a reference value R_B1 of the first battery bank B1, which is a potential diagnosis target having the greatest voltage variance with respect to a reference value, and a reference value R_B2 of the second battery bank B2.

In operation S102, the controller 220 may calculate, as a second deviation D2, a difference between a second voltage AV'_B1 of the first battery bank B1 and an average ΔV'_avg of second voltages ΔV' of the plurality of battery banks 110, 120, 130, and 140. The controller 220 may calculate, as the second deviation D2, an absolute value ABS of the difference between the second voltage AV'_B1 of the first battery bank B1 and the average ΔV'_avg of the second voltages ΔV' of the plurality of battery banks 110, 120, 130, and 140.

In operation S103, the controller 220 may determine whether the reference value R_B1 of the first battery bank B1 exceeds a first threshold. For example, the first threshold may be set to, e.g., '1.5'. In operation S103, the controller 220 may determine the first battery bank B1 having the greatest second voltage ΔV' among the plurality of battery banks 110, 120, 130, and 140 and then compare the reference value R_B1 of the first battery bank B1 with the preset first threshold to absolutely evaluate a voltage variance of the first battery bank B1.

In operation S104, the controller 220 may determine whether the first deviation D1 exceeds a second threshold. For example, the second threshold may be set to, e.g., *'0.5'*. In operation S104, the controller 220 may determine the first battery bank B1 having the greatest second voltage $\Delta V'$ and the second battery bank B2 having the second greatest second voltage $\Delta V'$ among the plurality of battery banks 110, 120, 130, and 140 and then compare the first deviation D1, which is the difference between the reference value R_B1 of the first battery bank B1 and the reference value R_B2 of the second battery bank B2, with the preset second threshold to absolutely evaluate the voltage variance of the first battery bank B1.

In operation S105, the controller 220 may determine whether the second deviation D2 exceeds a third threshold. For example, the third threshold may be set to, e.g., '10 mV'. In operation S105, the controller 220 may compare a difference between the second voltage $\Delta V'$ of the first battery bank B1 having the greatest second voltage $\Delta V'$ among the plurality of battery banks 110, 120, 130, and 140 and the average $\Delta V'$_avg of the second voltages $\Delta V'$ of the plurality of battery banks 110, 120, 130, and 140 with the preset third threshold.

In operation S106, the controller 220 may diagnose the first battery bank B1 as an abnormal battery bank when the reference value R_B1 of the first battery bank B1 exceeds the first threshold, the first deviation D1 exceeds the second threshold, and the second deviation D2 exceeds the third threshold, at the same time.

Referring back to FIG. 6, the controller 220 may diagnose the first battery bank B1 having the greatest second voltage $\Delta V'$ among the plurality of battery banks 110, 120, 130, and 140 when the reference value R_B1 of the first battery bank B1 exceeds the first threshold, the first deviation D1 exceeds the second threshold, and the second deviation D2 is less than the third threshold, at the same time.

According to an embodiment, the controller 220 may diagnose the first battery bank B1 as a battery bank including a battery cell having electrode tab disconnection occurring therein or a battery bank including a battery cell having electrode tab disconnection and lithium precipitation occurring therein when the reference value R_B1 of the first battery bank B1 exceeds the first threshold, the first deviation D1 exceeds the second threshold, and the second deviation D2 is less than the third threshold, at the same time.

The controller 220 may diagnose the first battery bank B1 as a battery bank including a battery cell having electrode tab disconnection occurring therein or a battery bank including a battery cell having electrode tab disconnection and lithium precipitation occurring therein and then track and monitor whether inner short occurs in the first battery bank B1.

When the controller 220 determines that electrode tab disconnection occurs or electrode tab disconnection and lithium precipitation occur in the first battery bank B1, as a result of diagnosis, the controller 220 may provide information about the first battery bank B1 to a user. For example, the controller 220 may provide information about the first battery bank B1 having electrode tab disconnection occurring or electrode tab disconnection and lithium precipitation occurring to a user terminal through a communication unit (not shown) and provide the information about the first battery bank B1 through a display provided in a vehicle, a charger, etc.

As described above, with the battery management apparatus 200 according to an embodiment disclosed herein, by using a voltage behavior of a rest period of battery banks, a battery bank including a battery cell having electrode tab disconnection occurring therein or a battery bank including a battery cell having electrode tab disconnection and lithium precipitation occurring therein may be diagnosed.

The battery management apparatus 200 may accurately diagnose a battery bank based on a voltage variance of a battery bank and ranks of voltage variances among battery banks.

Moreover, the battery management apparatus 200 may compare a plurality of voltage variances of a plurality of battery banks to analyze features of short-term voltage behavior and long-term voltage behavior of the battery banks.

The battery management apparatus 200 may secure safety and reliability of battery energy by early diagnosing a battery bank having electrode tab disconnection and lithium precipitation occurring therein using voltage variances of the battery banks. In addition, the battery management apparatus 200 may diagnose quickly and conveniently the battery bank because of no need to separately remove the battery by diagnosing the battery bank having electrode tab disconnection and lithium precipitation occurring therein in the state of the battery being mounted on a vehicle.

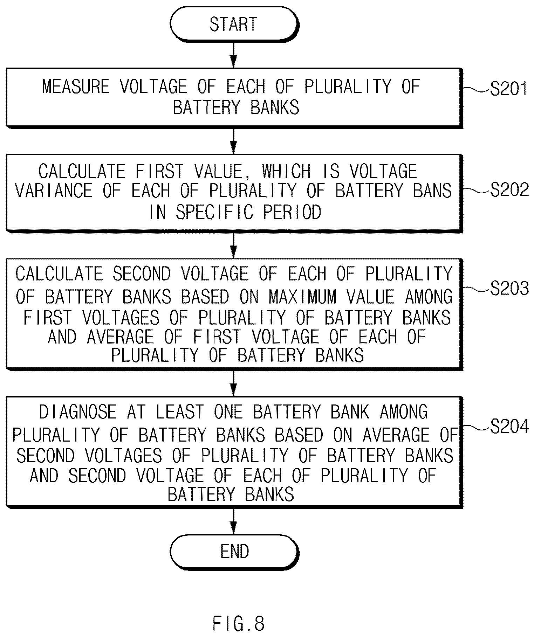

FIG. 8 is a flowchart showing an operating method of a battery management apparatus, according to an embodiment disclosed herein.

Hereinbelow, an operating method of the battery management apparatus 200 will be described with reference to FIGS. 1 and 7.

The battery management apparatus 200 may be substantially the same as the battery management apparatus 200 described with reference to FIGS. 1 to 7, and thus will be briefly described to avoid redundant description.

Referring to FIG. 8, the operating method of the battery management apparatus may include operation S201 of measuring a voltage of each of a plurality of battery banks, operation S202 of calculating a first voltage, which is a voltage variance of each of the plurality of battery banks in a specific period, operation S203 of calculating a second voltage of each of the plurality of battery banks based on a maximum value among the first voltages of the plurality of battery banks and an average of the first voltages of the plurality of battery banks, and operation S204 of diagnosing at least one battery bank among the plurality of battery banks based on an average of the second voltages of the plurality of battery banks and the second voltage of each of the plurality of battery banks.

Hereinbelow, operations S201 through S204 will be described in detail.

In operation S201, the voltage measurement unit 210 may calculate the voltage of each of the plurality of battery banks 110, 120, 130, and 140. The voltage measurement unit 210 may calculate time-series voltage data of each of the plurality of battery banks 110, 120, 130, and 140. Specifically, the voltage measurement unit 210 may calculate voltage rise and drop and long-term relaxation data of the plurality of battery banks 110, 120, 130, and 140 in charging, discharging, and rest periods.

In operation S201, the voltage measurement unit 210 may calculate the voltage of each of the plurality of battery banks 110, 120, 130, and 140 in the rest period after charging or discharging of the plurality of battery banks 110, 120, 130, and 140.

In operation S201, the voltage measurement unit 210 may calculate the voltage of each of the plurality of battery banks 110, 120, 130, and 140 in the rest period to calculate voltage change data of each of the plurality of battery banks 110, 120, 130, and 140. In the rest period, the battery bank having the disconnected electrode tab may have a faster and larger voltage change than the normal battery bank. Thus, the voltage measurement unit 210 may generate a graph indicating a voltage change of each of the plurality of battery banks 110, 120, 130, and 140 by measuring the voltage of each of the plurality of battery banks 110, 120, 130, and 140 in the rest period.

In operation S201, the voltage measurement unit 210 may calculate a voltage of each of the plurality of battery banks 110, 120, 130, and 140 at specific intervals set from a point in time after the elapse of a specific time of the rest period of the plurality of battery banks 110, 120, 130, and 140 and accumulate a voltage variance of each of the plurality of battery banks 110, 120, 130, and 140. Herein, the specific time may include, e.g., 600 seconds, and the specific period may include, e.g., 200 seconds or 600 seconds. In operation S201, for example, the voltage measurement unit 210 may calculate the voltage of each of the plurality of battery banks 110, 120, 130, and 140 at intervals of 200 seconds or 600 seconds from a point in time after the elapse of 600 seconds of the rest period of the plurality of battery banks 110, 120, 130, and 140.

In operation S202, the controller 220 may calculate a first voltage $\Delta V$ that is a voltage variance of each of the plurality of battery banks 110, 120, 130, and 140 in a specific period. In operation S202, for example, the controller 220 may calculate the first voltage $\Delta V$ that is a voltage variance during 200 seconds or 600 seconds from a point in time after the elapse of 600 seconds of the rest period of each of the plurality of battery banks 110, 120, 130, and 140.

In operation S202, the controller 220 may repeatedly calculate the first voltage $\Delta V$ of each of the plurality of battery banks 110, 120, 130, and 140 at specific intervals. In operation S202, for example, the controller 220 may repeatedly calculate the first voltage $\Delta V$ of each of the plurality of battery banks 110, 120, 130, and 140 at intervals of 200 seconds or 600 seconds. In operation S202, that is, the controller 220 may continuously compare a voltage measured at a point in time after the elapse of 600 seconds from a rest period of each of the plurality of battery banks 110, 120, 130, and 140, a voltage measured at a point in time after the elapse of 800 seconds from the rest period, and a voltage measured at a point in time after the elapse of 1000 seconds from the rest period with one another to calculate a change in the first voltage $\Delta V$ for each of the plurality of battery banks 110, 120, 130, and 140 at intervals of 200 seconds or 600 seconds.

In operation S203, the controller 220 may calculate the second voltage $\Delta V'$ of each of the plurality of battery banks based on the maximum value Max[$\Delta V$] among the first voltages $\Delta V$ of the plurality of battery banks 110, 120, 130, and 140 and the average voltage $\Delta V\_avg$ of the first voltages of the plurality of battery banks. In operation S203, the controller 220 may calculate the maximum value Max[$\Delta V$] among the first voltages $\Delta V$ of the plurality of battery banks 110, 120, 130, and 140. For example, the controller 220 may calculate the maximum value Max[$\Delta V$] among the first voltages $\Delta V$ of the plurality of battery banks 110, 120, 130, and 140 included in the same battery module.

In operation S203, the controller 220 may calculate an average $\Delta V\_avg$ of the first voltage of each of the plurality of battery banks 110, 120, 130, and 140. Specifically, the controller 220 may calculate the average $\Delta V\_avg$ of the first voltage of each of the plurality of battery banks 110, 120, 130, and 140 by using the first voltage $\Delta V$ of each of the plurality of battery banks 110, 120, 130, and 140, repeatedly measured up to a point in time at which the average $\Delta V\_avg$ of the first voltage of each of the plurality of battery banks 110, 120, 130, and 140 is calculated.

In operation S203, the controller 220 may compare the maximum value Max[$\Delta V$] among the first voltages $\Delta V$ of the plurality of battery banks 110, 120, 130, and 140 and the average $\Delta V\_avg$ of the first voltage $\Delta V$ of each of the plurality of battery banks 110, 120, 130, and 140 with the threshold. In operation S203, the controller 220 may correct the first voltage $\Delta V$ of each of the plurality of battery banks 110, 120, 130, and 140 based on a result of comparing the maximum value Max[$\Delta V$] among the first voltages $\Delta V$ of the plurality of battery banks 110, 120, 130, and 140 and the average $\Delta V\_avg$ of the first voltage $\Delta V$ of each of the plurality of battery banks 110, 120, 130, and 140 with the threshold.

In operation S203, the controller 220 may determine whether the maximum value Max[$\Delta V$] among the first voltages $\Delta V$ of the plurality of battery banks 110, 120, 130, and 140 exceeds the LT. Herein, the LT may be related to a noise level for determining whether the first voltage $\Delta V$ of each of the plurality of battery banks 110, 120, 130, and 140 is noise data. In operation S203, the controller 220 may compare the maximum value Max[$\Delta V$] among the first voltages $\Delta V$ of the

plurality of battery banks 110, 120, 130, and 140 with the LT to determine whether the first voltage $\Delta V$ of each of the plurality of battery banks 110, 120, 130, and 140 is noise data unavailable to diagnosis of a battery bank because of being extremely small. Herein, the LT may be, for example, '0.5 mV'.

In operation S203, according to an embodiment, the controller 220 may initialize the first voltage $\Delta V$ of each of the plurality of battery banks 110, 120, 130, and 140 when the maximum value Max[$\Delta V$] among the first voltages $\Delta V$ of the plurality of battery banks 110, 120, 130, and 140 is less than or equal to the LT. That is, the controller 220 may determine the first voltage $\Delta V$ of each of the plurality of battery banks 110, 120, 130, and 140 as noise data and initialize the first voltage $\Delta V$ without using the same for diagnosis of the battery bank, when the maximum value Max[$\Delta V$] among the first voltages $\Delta V$ of the plurality of battery banks 110, 120, 130, and 140 is less than or equal to the LT.

In operation S203, according to an embodiment, the controller 220 may maintain the first voltage $\Delta V$ of each of the plurality of battery banks 110, 120, 130, and 140 when the maximum value Max[$\Delta V$] among the first voltages $\Delta V$ of the plurality of battery banks 110, 120, 130, and 140 exceeds the LT. That is, the controller 220 may regard the magnitude of the first voltage $\Delta V$ of each of the plurality of battery banks 110, 120, 130, and 140 as being unignorable as noise data and use the first voltage $\Delta V$ for diagnosis of the battery bank, when the maximum value Max[$\Delta V$] among the first voltages $\Delta V$ of the plurality of battery banks 110, 120, 130, and 140 exceeds the LT.

In operation S203, according to an embodiment, the controller 220 may accumulate the first voltage $\Delta V$ of the battery bank when the maximum value Max[$\Delta V$] among the first voltages $\Delta V$ of the plurality of battery banks 110, 120, 130, and 140 exceeds the LT and the average $\Delta V\_avg$ of the first voltage of at least one of the plurality of battery banks 110, 120, 130, and 140 is less than an UT. Herein, the UT may be, for example, '1 mV'.

In operation S203, the controller 220 may accumulate the first voltage $\Delta V$ of the battery bank to diagnose the battery bank based on the accumulated amount of the first voltage $\Delta V$ in several periods when the maximum value Max[$\Delta V$] among the first voltages $\Delta V$ of the plurality of battery banks 110, 120, 130, and 140 exceeds the LT and the average $\Delta V\_avg$ of the first voltage $\Delta V$ of at least one of the plurality of battery banks 110, 120, 130, and 140 is less than the UT.

In operation S203, when the maximum value Max[$\Delta V$] among the first voltages $\Delta V$ of the plurality of battery banks 110, 120, 130, and 140 exceeds the LT and the average $\Delta V\_avg$ of the first voltage $\Delta V$ of at least one of the plurality of battery banks 110, 120, 130, and 140 is less than the UT, the controller 220 may not determine the first voltage $\Delta V$ as noise data, but as the magnitude of the first voltage $\Delta V$ is not sufficient to diagnose the battery bank, the controller 220 may accumulate the first voltage $\Delta V$ of the battery bank to diagnose the battery bank based on the accumulated amount of the first voltage $\Delta V$ in several periods. In operation S203, thus, the controller 220 may calculate a voltage of each of the plurality of battery banks 110, 120, 130, and 140 after the elapse of a specific period, add a newly calculated first voltage $\Delta V$ to a previously stored first voltage $\Delta V$, and compare the accumulatively calculated first voltage $\Delta V$ with the LT and the UT.

In operation S203, according to an embodiment, the controller 220 may accumulate the first voltage $\Delta V$ of the battery bank when the maximum value Max[$\Delta V$] among the first voltages $\Delta V$ of the plurality of battery banks 110, 120, 130, and 140 exceeds the LT and the average $\Delta V\_avg$ of the first voltage of at least one of the plurality of battery banks 110, 120, 130, and 140 is greater than or equal to the UT. The controller 220 may set the UT to prevent the first voltage $\Delta V$ of each of the plurality of battery banks 110, 120, 130, and 140 from being continuously accumulated. When the average $\Delta V\_avg$ of the first voltage $\Delta V$ of at least one of the plurality of battery banks 110, 120, 130, and 140 is greater than or equal to the UT, the controller 220 may accumulate the first voltage $\Delta V$ of the battery bank up to a point in time at which the average $\Delta V\_avg$ is determined to be greater than or equal to the UT, thereby calculating a second voltage $\Delta V'$ of the battery bank.

In operation S204, the controller 220 may diagnose at least one battery bank among the plurality of battery banks 110, 120, 130, and 140 based on the average $\Delta V'\_avg$ of the second voltages $\Delta V'$ of the plurality of battery banks 110, 120, 130, and 140 and the second voltage $\Delta V'$ of each of the plurality of battery banks 110, 120, 130, and 140.

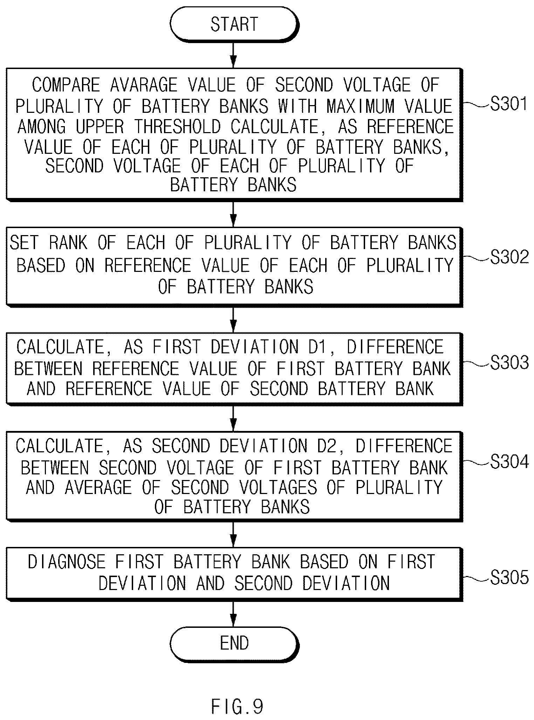

FIG. 9 is a flowchart of an operating method of a battery management apparatus according to another embodiment disclosed herein.

Hereinbelow, a method of diagnosing at least one battery bank among the plurality of battery banks 110, 120, 130, and 140 will be described in detail with reference to FIG. 9.

Referring to FIG. 9, in operation S301, the controller 220 may calculate an average $\Delta V'\_avg$ of the second voltage $\Delta V'$ of each of the plurality of battery banks 110, 120, 130, and 140. In operation S301, the controller 220 may calculate a maximum value Max between the average $\Delta V'\_avg$ of the second voltage $\Delta V'$ of each of the plurality of battery banks 110, 120, 130, and 140 and the UT.

In operation S301, the controller 220 may calculate a ratio of the second voltage $\Delta V'$ of each of the plurality of battery banks with respect to the maximum value between the average $\Delta V'\_avg$ of the second voltage $\Delta V'$ of each of the plurality of battery banks 110, 120, 130, and 140 and the UT. In operation S301, the controller 220 may calculate a ratio of the second voltage $\Delta V'$ of each of the plurality of battery banks with respect to the maximum value between the average $\Delta V'\_avg$ of the second voltage $\Delta V'$ of each of the plurality of battery banks 110, 120, 130, and 140 and the UT, as a reference value R of each of the plurality of battery banks 110, 120, 130, and 140.

In operation S301, the controller 220 may calculate the reference value R of each of the plurality of battery banks 110, 120, 130, and 140, based on Equation 2.

[Equation 2]

$$\text{Reference Value (R)} = \frac{\text{Second Voltage } (\Delta V')}{\max [\Delta V'\_avg, UT]}$$

In operation S301, the controller 220 may use a Max function for a denominator of [Equation 2] that calculates the reference value R. Specifically, the controller 220 may input a maximum value between the average $\Delta V'\_avg$ of the second voltage $\Delta V'$ of the plurality of battery banks 110, 120, 130, and 140 and the UT into the denominator of [Equation 2].

In operation S301, the controller 220 may be configured to diagnose a battery bank using the reference value R when a magnitude of the second voltage $\Delta V'$ of the battery bank is greater than or equal to a specific level by using the Max function for the denominator of [Equation 2].

In operation S301, the controller 220 may calculate the reference value R of each of the plurality of battery banks 110, 120, 130, and 140 at specific intervals. In operation S301, the controller 220 may calculate the first voltage $\Delta V$ of each of the plurality of battery banks 110, 120, 130, and 140 and the second voltage $\Delta V'$ obtained by correcting the first voltage $\Delta V$ at intervals of 200 seconds or 600 seconds, and calculate the reference value R of each of the plurality of battery banks 110, 120, 130, and 140 at intervals of 200 seconds or 600 seconds by using the calculated second voltage $\Delta V'$.

In operation S302, the controller 220 may set a rank of each of the plurality of battery banks 110, 120, 130, and 140 based on the reference value R of each of the plurality of battery banks 110, 120, 130, and 140. In operation S302, the controller 220 may list the plurality of battery banks 110, 120, 130, and 140 in a descending order with a larger reference value R. In operation S302, the controller 220 may sequentially set a rank according to an order in which the plurality of battery banks 110, 120, 130, and 140 are listed based on the reference values R. In operation S302, the controller 220 may determine a bank listed in a first rank based on the reference value R as a first battery bank B1 and a bank listed in a second rank based on the reference values R as a second battery bank B2, among the plurality of battery banks 110, 120, 130, and 140.

In operation S302, the controller 220 may determine the first battery bank B1 that is a potential diagnosis target based on the reference value R of each of the plurality of battery banks 110, 120, 130, and 140.

In operation S303, the controller 220 may calculate a difference 'R_B1 - R_B2' between a reference value R_B1 of the first battery bank B1 and a reference value R_B2 of the second battery bank B2 as a first deviation D1. In operation S303, the controller 220 may calculate, as a first deviation D1, a difference 'R_B1 - R_B2' between a reference value R_B1 of the first battery bank B1, which is a potential diagnosis target having the greatest voltage variance with respect to a reference value, and a reference value R_B2 of the second battery bank B2.

In operation S304, the controller 220 may calculate, as a second deviation D2, a difference between a second voltage $\Delta V'\_B1$ of the first battery bank B1 and an average $\Delta V'\_avg$ of second voltages $\Delta V'$ of the plurality of battery banks 110, 120, 130, and 140. In operation S304, the controller 220 may calculate, as the second deviation D2, an absolute value ABS of the difference between the second voltage $\Delta V'\_B1$ of the first battery bank B1 and the average $\Delta V'\_avg$ of the second voltages $\Delta V'$ of the plurality of battery banks 110, 120, 130, and 140.

In operation S305, the controller 220 may determine whether the reference value R_B1 of the first battery bank B1 exceeds a first threshold. For example, the first threshold may be set to, e.g., '1.5'. In operation S305, the controller 220 may determine the first battery bank B1 having the greatest second voltage $\Delta V'$ among the plurality of battery banks 110, 120, 130, and 140 and then compare the reference value R_B1 of the first battery bank B1 with the preset first threshold to absolutely evaluate a voltage variance of the first battery bank B1.

In operation S305, the controller 220 may determine whether the first deviation D1 exceeds a second threshold. For example, the second threshold may be set to, e.g., '0.5'. In operation S305, the controller 220 may determine the first battery bank B1 having the greatest second voltage $\Delta V'$ and the second battery bank B2 having the second greatest second voltage $\Delta V'$ among the plurality of battery banks 110, 120, 130, and 140 and then compare the first deviation D1, which is the difference between the reference value R_B1 of the first battery bank B1 and the reference value R_B2 of the second battery bank B2, with the preset second threshold to absolutely evaluate the voltage variance of the first battery bank B1.

In operation S305, the controller 220 may determine whether the second deviation D2 exceeds a third threshold. For example, the third threshold may be set to, e.g., '10 mV'. In operation S305, the controller 220 may compare a difference between the second voltage $\Delta V'$ of the first battery bank B1 having the greatest second voltage $\Delta V'$ among the plurality of battery banks 110, 120, 130, and 140 and the average $\Delta V'\_avg$ of the second voltages $\Delta V'$ of the plurality of battery banks 110, 120, 130, and 140 with the preset third threshold.

In operation S305, the controller 220 may diagnose the first battery bank B1 as an abnormal battery bank when the reference value R_B1 of the first battery bank B1 exceeds the first threshold, the first deviation D1 exceeds the second threshold, and the second deviation D2 exceeds the third threshold, at the same time.

In operation S305, the controller 220 may diagnose the first battery bank B1 having the greatest second voltage ΔV' among the plurality of battery banks 110, 120, 130, and 140 when the reference value R_B1 of the first battery bank B1 exceeds the first threshold, the first deviation D1 exceeds the second threshold, and the second deviation D2 is less than the third threshold, at the same time.

In operation S305, according to an embodiment, the controller 220 may diagnose the first battery bank B1 as a battery bank including a battery cell having electrode tab disconnection occurring therein or a battery bank including a battery cell having electrode tab disconnection and lithium precipitation occurring therein when the reference value R_B1 of the first battery bank B1 exceeds the first threshold, the first deviation D1 exceeds the second threshold, and the second deviation D2 is less than the third threshold, at the same time.

In operation S305, the controller 220 may diagnose the first battery bank B1 as a battery bank including a battery cell having electrode tab disconnection occurring therein or a battery bank including a battery cell having electrode tab disconnection and lithium precipitation occurring therein and then track and monitor whether inner short occurs in the first battery bank B1.

In operation S305, when the controller 220 determines that electrode tab disconnection occurs or electrode tab disconnection and lithium precipitation occur in the first battery bank B1, as a result of diagnosis, the controller 220 may provide information about the first battery bank B1 to a user. For example, the controller 220 may provide information about the first battery bank B1 having electrode tab disconnection occurring or electrode tab disconnection and lithium precipitation occurring to a user terminal through a communication unit (not shown) and provide the information about the first battery bank B1 through a display provided in a vehicle, a charger, etc.

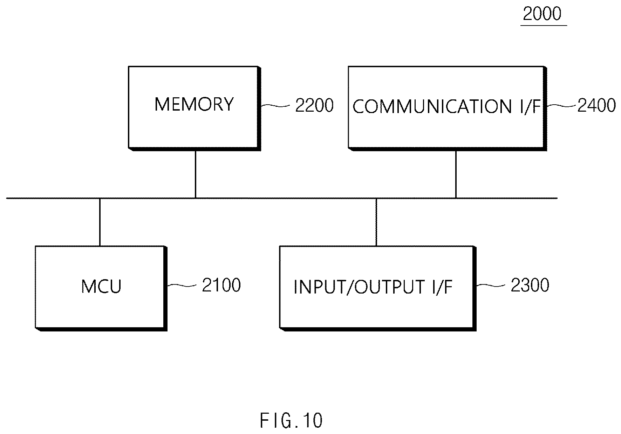

FIG. 10 is a block diagram showing a hardware configuration of a computing system for performing an operating method of a battery management apparatus, according to an embodiment disclosed herein.

Referring to FIG. 10, a computing system 2000 according to an embodiment disclosed herein may include a microcontroller unit (MCU) 2100, a memory 2200, an input/output interface (I/F) 2300, and a communication I/F 2400.

The MCU 2100 may be a processor that executes various programs (e.g., a battery voltage variance analysis program, etc.) stored in the memory 2200, processes various data through these programs, and perform the above-described functions of the battery management apparatus 200 shown in FIG. 1.

The memory 2200 may store various programs regarding operations of the battery management apparatus 200. Moreover, the memory 2200 may store operation data of the battery management apparatus 200.

The memory 2200 may be provided in plural, depending on a need. The memory 2200 may be volatile memory or non-volatile memory. For the memory 2200 as the volatile memory, random access memory (RAM), dynamic RAM (DRAM), static RAM (SRAM), etc., may be used. For the memory 2200 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 2200 are merely examples and are not limited thereto.

The input/output I/F 2300 may provide an interface for transmitting and receiving data by connecting an input device (not shown) such as a keyboard, a mouse, a touch panel, etc., and an output device such as a display (not shown), etc., to the MCU 2100.

The communication I/F 2400, which is a component capable of transmitting and receiving various data to and from a server, may be various devices capable of supporting wired or wireless communication. For example, a program for resistance measurement and abnormality diagnosis of the battery cell or various data may be transmitted and received to and from a separately provided external server through the communication I/F 2400.

The above description is merely illustrative of the technical idea of the present disclosure, and various modifications and variations will be possible without departing from the essential characteristics of the present disclosure by those of ordinary skill in the art to which the present disclosure pertains.

Therefore, the embodiments disclosed in the present disclosure are intended for description rather than limitation of the technical spirit of the present disclosure and the scope of the technical spirit of the present disclosure is not limited by these embodiments. The protection scope of the present disclosure should be interpreted by the following claims, and all technical spirits within the same range should be understood to be included in the range of the present disclosure.

## Claims

1. A battery management apparatus comprising:

   a voltage measurement unit configured to measure a voltage of each of a plurality of battery banks; and
   a controller configured to:

      calculate a first voltage, which is a voltage variance of each of the plurality of battery banks in a specific period;
      calculate a second voltage of each of the plurality of battery banks based on a maximum value among first voltages of the plurality of battery banks and an average of the first voltage of each of the plurality of battery banks; and

diagnose at least one battery bank among the plurality of battery banks based on an average value of second voltages of the plurality of battery banks and the second voltage of each of the plurality of battery banks.

2. The battery management apparatus of claim 1, wherein the controller is further configured to initialize the first voltage of each of the plurality of battery banks when the maximum value among the first voltages of the plurality of battery banks is less than or equal to a lower threshold (LT).

3. The battery management apparatus of claim 2, wherein the controller is further configured to accumulate the first voltage of each of the plurality of battery banks when the maximum value among the first voltages of the plurality of battery banks exceeds the LT and the average the first voltages of the plurality of battery banks is less than an upper threshold (UT).

4. The battery management apparatus of claim 3, wherein the controller is further configured to calculate the first voltage of each of the plurality of battery banks as the second voltage of each of the plurality of battery banks when the maximum value among the first voltages of the plurality of battery banks exceeds the LT and the average the first voltages of the plurality of battery banks is greater than or equal to the UT.

5. The battery management apparatus of claim 4, wherein the controller is further configured to calculate, as a reference value of each of the plurality of battery banks, a ratio of the second voltage of the plurality of battery banks with respect to the maximum value between the average of the second voltages of the plurality of battery banks and the UT.

6. The battery management apparatus of claim 5, wherein the controller is further configured to set a rank of each of the plurality of battery banks based on the reference value of each of the plurality of battery banks.

7. The battery management apparatus of claim 6, wherein the controller is further configured to set a rank according to an order in which the plurality of battery banks are listed in an ascending order of the reference value, and determine a first battery bank in a first rank and a second battery bank in a second rank among the plurality of battery banks.

8. The battery management apparatus of claim 7, wherein the controller is further configured to:

calculate a first deviation which is a difference between a reference value of the first battery bank and a reference value of the second battery bank;

calculate a second deviation which is a difference between a second voltage of the first battery bank and an average value of second voltages of the plurality of battery banks; and

diagnose the first battery bank based on the first deviation and the second deviation.

9. The battery management apparatus of claim 8, wherein the controller is further configured to diagnose the first battery bank when the reference value of the first battery bank exceeds a first threshold, the first deviation is less than a second threshold, and the second deviation exceeds a third threshold.

10. An operating method of a battery management apparatus, the operating method comprising:

measuring a voltage of each of a plurality of battery banks;

calculating a first voltage, which is a voltage variance of each of the plurality of battery banks in a specific period;

calculating a second voltage of each of the plurality of battery banks based on a maximum value among first voltages of the plurality of battery banks and an average of the first voltage of each of the plurality of battery banks; and

diagnosing at least one battery bank among the plurality of battery banks based on an average value of second voltages of the plurality of battery banks and the second voltage of each of the plurality of battery banks.

11. The operating method of claim 10, wherein the calculating of the second voltage of each of the plurality of battery banks based on the maximum value among the first voltages of the plurality of battery banks and the average of the first voltage of each of the plurality of battery banks comprises initializing the first voltage of each of the plurality of battery banks when the maximum value among the first voltages of the plurality of battery banks is less than or equal to a lower threshold (LT).

12. The operating method of claim 11, wherein the calculating of the second voltage of each of the plurality of battery banks based on the maximum value among the first voltages of the plurality of battery banks and the average of the first voltage of each of the plurality of battery banks comprises accumulating the first voltage of each of the plurality of battery banks when the maximum value among the first voltages of the plurality of battery banks exceeds the LT and the average the first voltages of the plurality of battery banks is less than an upper threshold (UT).

13. The operating method of claim 12, wherein the calculating of the second voltage of each of the plurality of battery banks based on the maximum value among the first voltages of the plurality of battery banks and the average of the first voltage of each of the plurality of battery banks comprises calculating the first voltage of each of the plurality of battery banks as the second voltage of each of the plurality of battery banks when the maximum value among the first voltages of the plurality of battery banks exceeds the LT and the average the first voltages of the plurality of battery banks is greater than or equal to the UT.

14. The operating method of claim 13, wherein the setting of the rank of each of the plurality of battery banks based on the reference value which is a ratio of the second voltage of each of the plurality of battery banks with respect to an average of the second voltages of the plurality of battery banks comprises calculating, as a reference value of each of the plurality of battery banks, a ratio of the second voltage of the plurality of battery banks with respect to the maximum value between the average of the second voltages of the plurality of battery banks and the UT.

15. The operating method of claim 14, wherein the diagnosing of the at least one battery bank among the plurality of battery banks based on the average value of the second voltages of the plurality of battery banks and the second voltage of each of the plurality of battery banks comprises setting a rank of each of the plurality of battery banks based on the reference value of each of the plurality of battery banks.

16. The operating method of claim 15, wherein the diagnosing of the at least one battery bank among the plurality of battery banks based on the average value of the second voltages of the plurality of battery banks and the second voltage of each of the plurality of battery banks comprises setting a rank according to an order in which the plurality of battery banks are listed in an ascending order of the reference value, and determine a first battery bank in a first rank and a second battery bank in a second rank among the plurality of battery banks.

17. The operating method of claim 16, wherein the diagnosing of the at least one battery bank among the plurality of battery banks based on the average value of the second voltages of the plurality of battery banks and the second voltage of each of the plurality of battery banks comprises:

    calculating a first deviation which is a difference between a reference value of the first battery bank and a reference value of the second battery bank;
    calculating a second deviation which is a difference between a second voltage of the first battery bank and an average value of second voltages of the plurality of battery banks; and
    diagnosing the first battery bank based on the first deviation and the second deviation.

18. The operating method of claim 17, wherein the diagnosing of the at least one battery bank among the plurality of battery banks based on the average value of the second voltages of the plurality of battery banks and the second voltage of each of the plurality of battery banks comprises diagnosing the first battery bank when the reference value of the first battery bank exceeds a first threshold, the first deviation is less than a second threshold, and the second deviation exceeds a third threshold.

1000

300

100

110

120

130

140

BATTERY MANAGEMENT
APPARATUS
200

FIG.1

200

| VOLTAGE MEASUREMENT UNIT 210 | CONTROLLER 220 |

FIG.2

FIG.3

FIG.4

FIG.5

FIG.6

START

CALCULATE, AS FIRST DEVIATION D1, DIFFERENCE BETWEEN REFERENCE VALUE OF FIRST BATTERY BANK AND REFERENCE VALUE OF SECOND BATTERY BANK — S101

CALCULATE, AS SECOND DEVIATION D2, DIFFERENCE BETWEEN SECOND VOLTAGE OF FIRST BATTERY BANK AND AVERAGE OF SECOND VOLTAGES OF PLURALITY OF BATTERY BANKS — S102

YES

S103

REFERENCE VALUE OF FIRST BATTERY BANK > FIRST THRESHOLD?     NO

YES

S104

FIRST DEVIATION D1 > SECOND THRESHOLD?     NO

YES

S105

SECOND DEVIATION D2 < THIRD THRESHOLD?     NO

YES

DIAGNOSE FIRST BATTERY BANK — S106

END

FIG.7

START

MEASURE VOLTAGE OF EACH OF PLURALITY OF BATTERY BANKS ~S201

CALCULATE FIRST VALUE, WHICH IS VOLTAGE VARIANCE OF EACH OF PLURALITY OF BATTERY BANS IN SPECIFIC PERIOD ~S202

CALCULATE SECOND VOLTAGE OF EACH OF PLURALITY OF BATTERY BANKS BASED ON MAXIMUM VALUE AMONG FIRST VOLTAGES OF PLURALITY OF BATTERY BANKS AND AVERAGE OF FIRST VOLTAGE OF EACH OF PLURALITY OF BATTERY BANKS ~S203

DIAGNOSE AT LEAST ONE BATTERY BANK AMONG PLURALITY OF BATTERY BANKS BASED ON AVERAGE OF SECOND VOLTAGES OF PLURALITY OF BATTERY BANKS AND SECOND VOLTAGE OF EACH OF PLURALITY OF BATTERY BANKS ~S204

END

FIG.8

FIG.9

24

2000

MEMORY ~ 2200    COMMUNICATION I/F ~2400

MCU ~ 2100    INPUT/OUTPUT I/F ~ 2300

FIG.10

## INTERNATIONAL SEARCH REPORT

| | International application No. |
|---|---|
| | **PCT/KR2024/006658** |

---

### A. CLASSIFICATION OF SUBJECT MATTER

**G01R 31/392**(2019.01)i; **G01R 31/396**(2019.01)i; **G01R 31/385**(2019.01)i; **G01R 31/12**(2006.01)i; **G01R 19/10**(2006.01)i; **G01R 19/30**(2006.01)i; **G01R 19/00**(2006.01)i; **G01R 19/165**(2006.01)i

According to International Patent Classification (IPC) or to both national classification and IPC

### B. FIELDS SEARCHED

Minimum documentation searched (classification system followed by classification symbols)

G01R 31/392(2019.01); G01R 31/36(2006.01); G01R 31/367(2019.01); G01R 31/50(2020.01); H01M 10/42(2006.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 전압(voltage), 변화량(difference), 최대(maximum), 평균(mean), 진단(diagnosis), 석출(precipitation)

### C. DOCUMENTS CONSIDERED TO BE RELEVANT

| Category* | Citation of document, with indication, where appropriate, of the relevant passages | Relevant to claim No. |
|---|---|---|
| X | KR 10-2022-0146255 A (LG ENERGY SOLUTION, LTD.) 01 November 2022 (2022-11-01)<br>See paragraphs [0007]-[0161]; and figures 2-7. | 1,10 |
| Y | | 2-3,11-12 |
| A | | 4-9,13-18 |
| Y | KR 10-2125462 B1 (DAUMKOREA CO., LTD.) 23 June 2020 (2020-06-23)<br>See paragraphs [0042] and [0087]. | 2-3,11-12 |
| A | KR 10-2362208 B1 (SAMSUNG SDI CO., LTD.) 10 February 2022 (2022-02-10)<br>See claims 1-2; and figures 1-2. | 1-18 |
| A | KR 10-2017-0023583 A (LG CHEM, LTD.) 06 March 2017 (2017-03-06)<br>See paragraph [0033]; and figure 1. | 1-18 |

☑ Further documents are listed in the continuation of Box C.     ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **21 August 2024** | **22 August 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

| International application No. |
|---|
| **PCT/KR2024/006658** |

**C.    DOCUMENTS CONSIDERED TO BE RELEVANT**

| Category* | Citation of document, with indication, where appropriate, of the relevant passages | Relevant to claim No. |
|---|---|---|
| A | KR 10-2023-0057894 A (LG ENERGY SOLUTION, LTD.) 02 May 2023 (2023-05-02)<br>See claims 1-2; and figure 1. | 1-18 |

Form PCT/ISA/210 (second sheet) (July 2022)

## INTERNATIONAL SEARCH REPORT
### Information on patent family members

International application No.

**PCT/KR2024/006658**

| Patent document cited in search report | | | Publication date (day/month/year) | Patent family member(s) | | | Publication date (day/month/year) |
|---|---|---|---|---|---|---|---|
| KR | 10-2022-0146255 | A | 01 November 2022 | None | | | |
| KR | 10-2125462 | B1 | 23 June 2020 | KR | 10-2020-0021368 | A | 28 February 2020 |
| KR | 10-2362208 | B1 | 10 February 2022 | KR | 10-2021-0059566 | A | 25 May 2021 |
| KR | 10-2017-0023583 | A | 06 March 2017 | CN | 107112605 | A | 29 August 2017 |
| | | | | CN | 107112605 | B | 11 February 2020 |
| | | | | EP | 3226016 | A1 | 04 October 2017 |
| | | | | EP | 3226016 | B1 | 06 January 2021 |
| | | | | JP | 2018-528573 | A | 27 September 2018 |
| | | | | JP | 6731041 | B2 | 29 July 2020 |
| | | | | KR | 10-1897859 | B1 | 12 September 2018 |
| | | | | US | 10126367 | B2 | 13 November 2018 |
| | | | | US | 2017-0234930 | A1 | 17 August 2017 |
| | | | | WO | 2017-034135 | A1 | 02 March 2017 |
| KR | 10-2023-0057894 | A | 02 May 2023 | CN | 116829966 | A | 29 September 2023 |
| | | | | EP | 4321884 | A1 | 14 February 2024 |
| | | | | JP | 2024-500893 | A | 10 January 2024 |
| | | | | WO | 2023-068899 | A1 | 27 April 2023 |

Form PCT/ISA/210 (patent family annex) (July 2022)

**EP 4 675 291 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230064031